# FASCICULE DE BREVET EUROPEEN

(11) **EP 1 085 794 B1**
(45) Date de publication et mention de la délivrance du brevet: **22.10.2003**
(21) Numéro de dépôt: 00402421.2
(22) Date de dépôt: 01.09.2000
(51) Int. Cl.: H05K 7/10

(54) **Boîtier d'interconnexion pour composants électroniques**
Verdrahtungsgehäuse für Schaltungskomponenten
Junction box for electronic components

(30) Priorité: 15.09.1999 FR 9911536
(43) Date de publication de la demande: 21.03.2001
(73) Titulaire: CONNECTEURS CINCH, Société Anonyme dite :, F-78190 Montigny Le Bretonneux (FR)
(72) Inventeur: Thuault, Michel, 78700 Conflans Sainte-Honorine (FR); Ittah, Jean, 92390 Villeneuve la Garenne (FR); Badaroux, Thierry, 78100 Saint-Germain en Laye (FR)
(74) Mandataire: Faber, Jean-Paul

(56) Documents cités:
- EP-A- 0 145 327
- EP-A- 0 214 719
- GB-A- 2 114 821

## Description

La présente invention se rapporte à un boîtier d'interconnexion pour composants électroniques.

L'invention se rapporte au montage de composants électroniques sur des circuits imprimés et plus particulièrement des composants électroniques H.F. qui, d'une part, sont sensibles à des températures élevées et, d'autre part, imposent d'avoir des longueurs de contact relativement courtes, car de tels composants sont particulièrement sensibles aux perturbations électromagnétiques.

Actuellement, pour le montage des composants électroniques sur des circuits imprimés, on connaît deux techniques industrielles. La première technique dite : "soudage à la vague" nécessite, soit de faire traverser l'épaisseur des circuits imprimés par des barrettes solidaires des contacts de composants, ces barrettes dans le cas des composants H.F. constituent des antennes captant les perturbations électromagnétiques avoisinantes ; soit de souder les composants en surface des circuits imprimés, ces composants devant alors passer dans un bain de soudure en fusion, ce qui à pour effet de les soumettre à des contraintes thermiques importantes.

La seconde technique consiste, dans le cas des composants soudés en surface, à disposer une substance de soudage sur le circuit imprimé, les composants sont alors posés sur cette dernière et l'ensemble passe dans un four dit "à refusion" dont la température est de l'ordre de 250 à 300°C. Une telle technique ne peut être utilisée pour les composants H.F. qui sont particulièrement sensibles aux températures élevées.

L'un des buts de la présente invention est de réaliser un boîtier permettant le montage de composants H.F. sur des circuits imprimés, d'une manière industrielle et en évitant les inconvénients des techniques précitées.

Le boîtier d'interconnexion pour composants électroniques, selon l'invention, est destiné à des composants dont une face présente une série de contacts, ledit boîtier étant formé d'un corps comportant un logement pour recevoir le composant, des moyens pour sa fixation sur le circuit imprimé, des moyens pour assurer la liaison électrique avec les pistes du circuit imprimé et les contacts du composant, et des moyens de verrouillage du composant dans le logement ledit boîtier étant caractérisé en ce que le logement du composant est constitué par un réceptacle indépendant du corps qui comporte un fond et des parois latérales, le fond étant percé de trous destinés à recevoir des plots de contact destinés, par une extrémité correspondante, à coopérer et à être soudés sur les pistes du circuit imprimé, tandis que le réceptacle comporte un fond percé de lumières dans lesquelles sont engagés des boutons de contact électrique formés d'un enchevêtrement d'un fil pour obtenir une sorte de tampon élastique, l'une des extrémités des boutons portant contre l'extrémité correspondante des plots de contact et l'autre extrémité contre les contacts du composant électronique.

Grâce à une telle disposition, on peut souder en surface, sur le circuit imprimé, les moyens de liaison électrique des pistes et des contacts du composant, préalablement à sa mise en place dans le logement, de sorte que ledit composant ne risque pas d'être endommagé par la chaleur.

Suivant encore une caractéristique constructive, les plots de contact comportent, en un point intermédiaire de leur longueur, une virole, tandis que les trous du fond du corps présentent, du côté de la face interne du fond, un diamètre correspondant à la virole et, du côté de la face externe dudit fond, un diamètre plus petit correspondant à l'extrémité des plots destinée, à coopérer et à être soudée sur les pistes du circuit imprimé, ces deux diamètres des trous étant raccordés par un épaulement.

Suivant un détail constructif, les lumières destinées à être traversées par les boutons affectent, du côté de la face interne du réceptacle, la forme d'un tronc de cône renversé et, du côté de la face externe dudit fond, la forme d'un tronc de cône, les petites bases de ces troncs de cône étant raccordées par une partie intermédiaire cylindrique. Ainsi, les boutons sont retenus dans les lumières, même si le composant n'est pas mis en place dans le réceptacle.

Suivant un mode de réalisation particulier, le corps comporte une série de plots destinés à être soudés en des points du circuit imprimé et constituant les moyens de fixation dudit corps sur le circuit imprimé.

Suivant une caractéristique de détail les moyens de verrouillage du composant électronique dans le logement comprennent un volet articulé sur le corps par une extrémité et dont l'autre extrémité vient s'emboîter dans des crochets élastiques solidaires du corps.

Afin d'assurer une bonne liaison électrique entre les différents contacts, le volet est constitué par une lame cambrée en un point intermédiaire de sa longueur et dont la convexité est tournée vers le logement. Ainsi, les contacts du composant électronique sont pressés élastiquement contre les boutons.

Afin que les boutons soient parfaitement maintenus dans les lumières durant le transport, le stockage et le montage du boîtier sur le circuit imprimé, il est prévu une cale destinée à être montée dans le logement et qui est retirée pour être remplacée par le composant électrique lorsque le boîtier est fixé sur le circuit imprimé.

L'invention va maintenant être décrite avec plus de détails en se référant à un mode de réalisation particulier donné à titre d'exemple seulement et représenté aux dessins annexés, dans lesquels :

Figure 1 est une vue en perspective éclatée d'un boîtier, selon l'invention.

Figure 2 montre en perspective le boîtier monté ouvert.

Figure 3 montre en perspective le boîtier fermé.

Figure 4 montre en perspective un composant électronique destiné à être monté dans le boîtier.

Figure 5 est une vue en coupe suivant la ligne 5-5 de la figure 1.

Figure 6 est une vue en coupe suivant la ligne 6-6 de la figure 3.

Figure 7 est une vue en coupe suivant la ligne 7-7 de la figure 3.

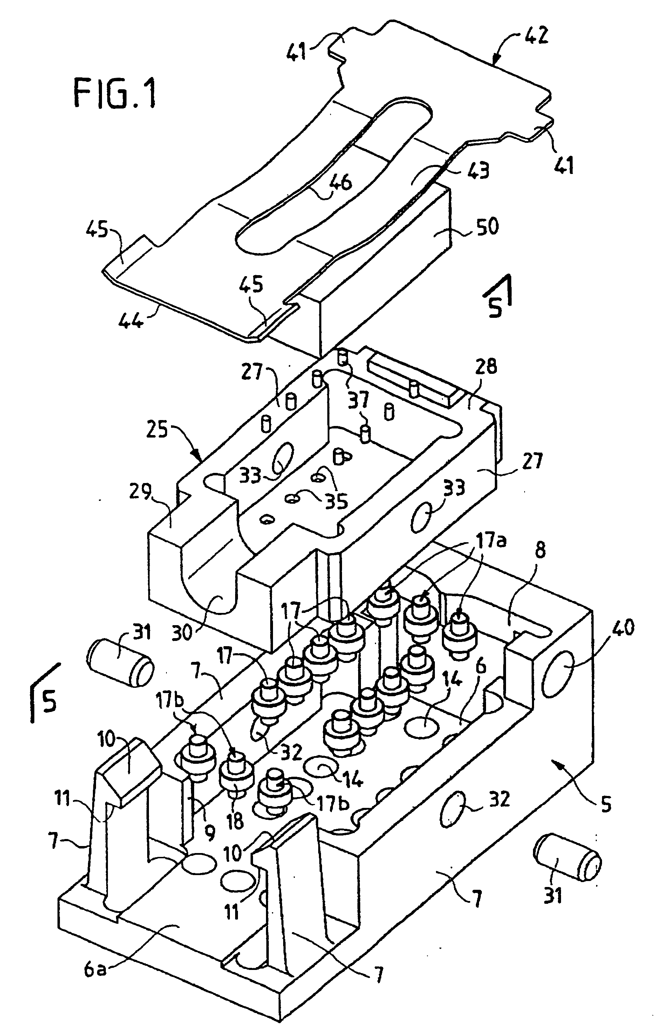

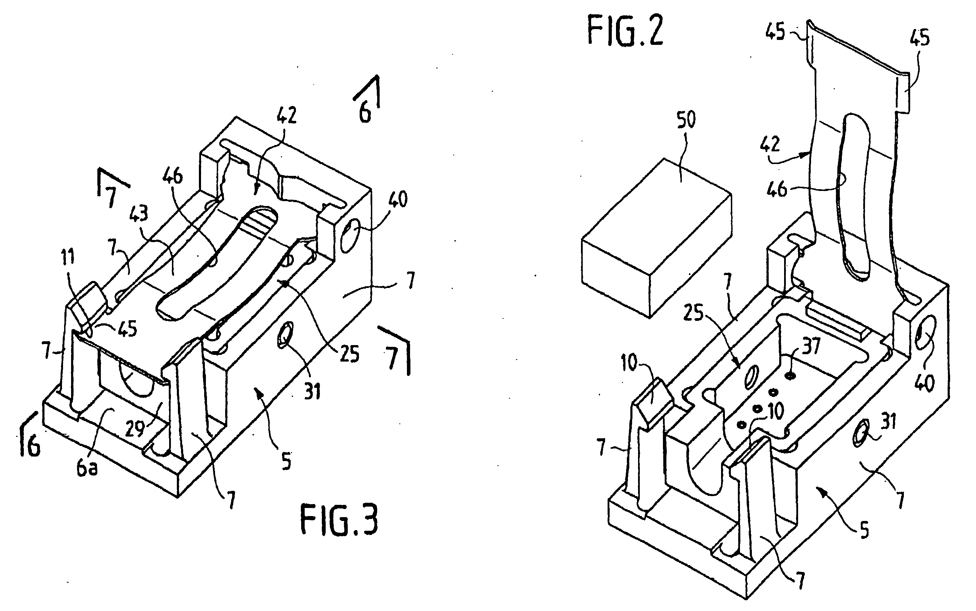

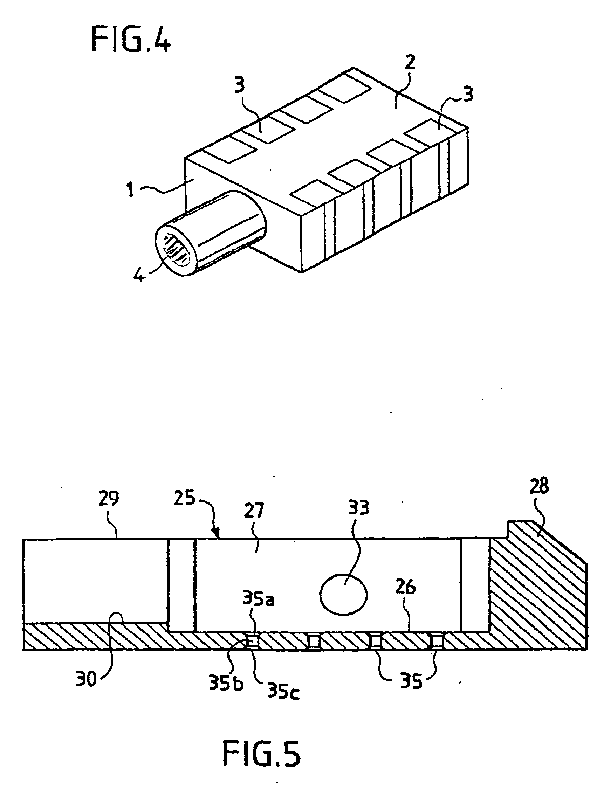

Aux figures 1 à 7, on a représenté un boîtier d'interconnexion pour des composants électroniques sensibles, tels que des composants H.F. qui, comme représentés à la figure 4, se présentent sous la forme d'un bloc parallélépipédique 1 dont une face 2 présente une série de contacts 3 qui sont dorés, l'une des parois comportant un manchon 4 de réception d'une fibre optique.

Le boîtier, comprend un corps 5 avec un fond 6, deux parois latérales longitudinales 7 et une paroi d'extrémité 8.

Du côté opposé à la paroi 8, le corps 5 comporte un passage de guidage 9, tandis que le fond comporte, au-delà du passage 9, un prolongement 6a à partir duquel s'érigent deux crochets 12.

Les crochets 12 se font vis-à-vis et comportent, à leur extrémité libre sur leur face tournée en regard l'une de l'autre, deux rampes inclinées 10 se terminant par un abrupt 11.

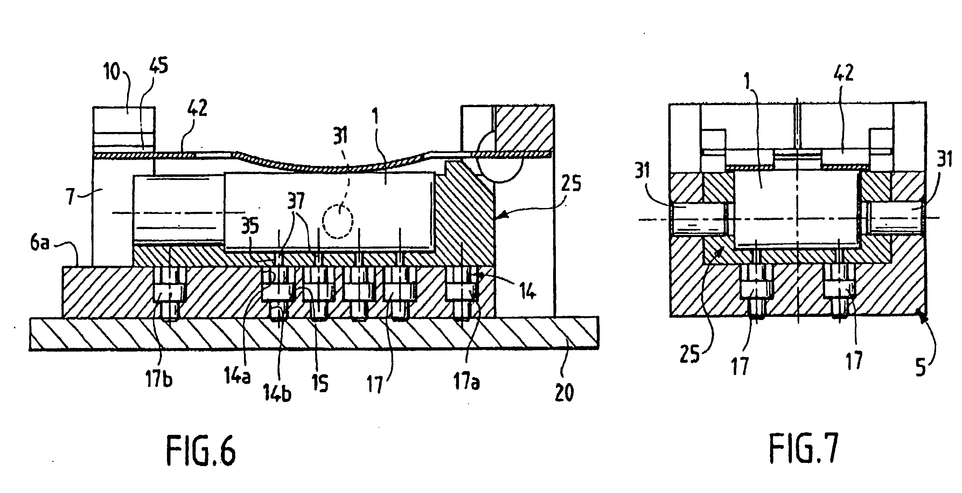

Le fond 6 (voir figures 6 et 7) comporte une série de trous 14 qui, du côté de la face interne dudit fond présentent un grand diamètre 14a et, du côté de la face externe du fond, un petit diamètre 14b, ces deux diamètres étant raccordés par un épaulement 15.

Ces trous sont destinés à recevoir des plots de contact 17 qui présentent, en un point intermédiaire de leur longueur, une virole 18. La partie des plots 17 destinée à traverser le petit diamètre 14b a un diamètre correspondant à celui-ci, tandis que la virole 18 a un diamètre correspondant au grand diamètre 14a.

Dans ce mode de réalisation, les trois plots 17a situés au voisinage de la paroi d'extrémité 8 et les trois plots 17b situés au voisinage du passage 9 sont destinés à la fixation du corps 5 sur un circuit imprimé 20. La liaison entre les plots 17a et 17b et le circuit imprimé 20 s'effectuant par une technique de soudage par refusion, technique dans laquelle le circuit imprimé comporte des points avec une substance de soudage qui assure, après chauffage dans un four à refusion, la soudure avec l'extrémité des plots 17a et 17b correspondants.

Le corps 5 est destiné à recevoir un réceptacle 25 pour le composant 1.

Le réceptacle 25 comporte un fond 26 avec deux parois longitudinales 27, une paroi d'extrémité 28 et une paroi 29 prolongée pour s'étendre jusqu'au voisinage des crochets 12 et dans laquelle est conformée une gouttière 30.

Le réceptacle 25 est destiné à s'emboîter dans le corps 5 et à être fixé dans celui-ci par des chevilles 31 traversant des trous 32 des parois 7 et des trous 33 des parois 27.

Le fond 26 est percé d'une série de lumières 35 (voir figure 5) qui présentent, du côté de la face interne dudit fond 26, une partie en forme de tronc de cône renversé 35a et, du côté de la face externe du fond 26, une partie 35c en forme de tronc de cône, les petites bases de ces troncs de cône étant raccordées par une partie intermédiaire cylindrique 35b.

Les lumières 35 sont destinées à recevoir des boutons de contact électrique 37 formés d'un enchevêtrement d'un fil pour obtenir une sorte de tampon ayant une certaine élasticité. Compte tenu de la forme des lumières 35, les boutons 37 sont retenus dans lesdites lumières.

Les parois 7, au voisinage de la paroi 8, comportent, chacune, une ouverture circulaire 40 destinée à recevoir des languettes 41 d'un volet de verrouillage 42.

Le volet 42 est formé d'une lame métallique élastique présentant une partie cintrée 43 dont la convexité est tournée vers le fond 26, une large fente 46 étant ménagée longitudinalement, ledit volet, du côté de son extrémité 44 opposée à celle adjacente aux languettes 41, comportant latéralement des pattes 45 légèrement pliées du côté opposé à la convexité de la partie 43.

Le volet 42 se verrouille par une simple pression de manière que les pattes 45, dans un premier temps, coopèrent avec les rampes 10, puis s'insèrent sous les abrupts 11.

Dans le mode de réalisation représenté, le corps 5 comporte huit plots de contact 17 dont l'extrémité destinée à coopérer avec les pistes du circuit imprimé 20 est étamée, tandis que les autres extrémités sont dorées et destinées à porter contre les boutons 37 qui portent contre les contacts 3 du composant 1.

La référence 50 désigne une cale qui affecte la même forme et les mêmes dimensions que le composant 1.

Le boîtier d'interconnexion est livré avec la cale 50 montée dans le réceptacle 25, et il est fixé sur le circuit imprimé 20, en même temps que les parties correspondantes des plots 17 sont soudées sur les pistes convenables, cette opération s'effectuant à une température de l'ordre de 200 à 300°C. Après que le boîtier ait été ainsi solidarisé au circuit imprimé 20, on ouvre le volet 42, on retire la cale 50 et on met en place le composant 1 de manière que ses contacts 3 portent contre les boutons 37 et que le manchon 4 s'étende dans la gouttière 30, puis on referme le volet 42.

On conçoit que le composant 1 n'est ainsi pas soumis à la chaleur et que ses contacts 3 étant les plus courts possible, on évite les perturbations électromagnétiques.

Bien entendu, l'invention n'est pas limitée au mode de réalisation qui vient d'être décrit et représenté. On pourra y apporter de nombreuses modifications de détail sans sortir pour cela du cadre de l'invention.

## Revendications

1. Boîtier d'interconnexion pour composants électroniques du type dont une face présente une série de contacts (3), ledit boîtier étant formé d'un corps (5) comportant un logement pour recevoir le composant (1), des moyens étant prévus, d'une part, pour la fixation dudit corps sur le circuit imprimé (20) et, d'autre part, pour assurer la liaison électrique avec les pistes du circuit imprimé (20) et les contacts (3) du composant (1), et des moyens de verrouillage (42) du composant (1) dans le logement, **caractérisé en ce que** le logement est constitué par un réceptacle (25) indépendant dudit corps (5) et destiné à recevoir le composant, tandis que ledit corps (5) comporte un fond (6) et des parois latérales (7, 8), le fond (6) étant percé de trous (14) destinés à recevoir des plots de contact (17) destinés, par une extrémité correspondante, à coopérer et à être soudés sur les pistes du circuit imprimé, tandis que le réceptacle (25) comporte un fond (26) percé de lumières (35) dans lesquelles sont engagés des boutons (37) de contact électrique formés d'un enchevêtrement d'un fil pour obtenir une sorte de tampon élastique, l'une des extrémités des boutons (37) portant contre l'extrémité correspondante des plots de contact (17) et l'autre extrémité contre les contacts (3) du composant électronique (1).

2. Boîtier d'interconnexion pour composants électroniques, selon la revendication 1, **caractérisé en ce que** les plots de contact (17) comportent, en un point intermédiaire de leur longueur, une virole (18) tandis que les trous (14) du fond (6) du corps (5) présentent, du côté de la face interne du fond, un diamètre (14a) correspondant à la virole (18) et, du côté de la face externe dudit fond, un diamètre plus petit (14b) correspondant à l'extrémité des plots (17) destinée à coopérer et à être soudée sur les pistes du circuit imprimé, ces deux diamètres des trous étant raccordés par un épaulement (15).

3. Boîtier d'interconnexion pour composants électroniques, selon la revendication 1, **caractérisé en ce que** les lumières (35) destinées à être traversées par les boutons (37) affectent, du côté de la face interne du réceptacle, la forme d'un tronc de cône renversé (35a) et, du côté de la face externe dudit fond, la forme d'un tronc de cône (35c), les petites bases de ces troncs de cône étant raccordées par une partie intermédiaire cylindrique (35b).

4. Boîtier d'interconnexion pour composants électroniques, selon la revendication 1, **caractérisé en ce que** le corps (5) comporte une série de plots (17a, 17b) destinés à être soudés en des points du circuit imprimé et constituant les moyens de fixation dudit corps sur le circuit imprimé.

5. Boîtier d'interconnexion pour composants électroniques, selon la revendication 1, **caractérisé en ce que** les moyens de verrouillage du composant électronique dans le logement comprennent un volet (42) constitué par une lame cambrée en un point intermédiaire de sa longueur et dont la convexité est tournée vers le réceptacle, ledit volet (42) étant articulé sur le corps (5) par une extrémité, tandis que l'autre extrémité vient s'emboîter dans des crochets élastiques (12) solidaires du corps (5).

6. Boîtier d'interconnexion pour composants électroniques, selon la revendication 1, **caractérisé en ce qu'**il comporte une cale (50) ayant les dimensions du composant électronique (1) et destinée à être montée dans le logement lors du stockage, du transport et du montage dudit boîtier sur le circuit imprimé.

## Patentansprüche

1. Verbindergehäuse für elektronische Bauteile deren eine Seite eine Reihe von Kontakten (3) aufweist, wobei genanntes Gehäuse aus einem Körper (5) gebildet ist, der einen Sitz für die Aufnahme des Bauteiles (1) aufweist, wobei Mittel, um einerseits den genannten Körper auf einer gedruckten Schaltung (20) zu befestigen und andererseits die elektrische Verbindung mit den Leiterbahnen der gedruckten Schaltung (20) und den Kontakten (3) des Bauteiles sicher zu stellen, sowie Mittel vorgesehen sind, um das Bauteil (1) in dem Sitz zu verriegeln, **dadurch gekennzeichnet, dass** der Sitz durch einen Behälter (25) gebildet ist, der von dem genannten Körper (5) unabhängig und dazu vorgesehen ist, das Bauteil aufzunehmen, und dass der genannte Körper (5) einen Boden (6) und Seitenwände (7, 8) aufweist, wobei der Boden (6) von Löchern (14) durchzogen ist, die zur Aufnahme von Kontaktsatzpins (17) bestimmt sind, die dazu vorgesehen sind, mit einem entsprechenden Ende mit den Leiterbahnen der gedruckten Schaltung zusammen zu wirken und verlötet zu sein, während der Behälter (25) einen Boden (26) aufweist, der von Öffnungen (35) durchzogen ist, in denen Köpfe (37) elektrischer Kontakte sitzen, die durch einen Drahtwickel gebildet sind, um eine Art elastisches Kissen zu erhalten, wobei eines der Enden der Köpfe (37) sich gegen das entsprechende Ende der Kontaktsatzpins (17) und das andere Ende sich gegen die Kontakte (3) des elektronischen Bauteiles (1) abstützen.

2. Verbindergehäuse für elektronische Bauteile nach Anspruch 1, **dadurch gekennzeichnet, dass** die Kontaktsatzpins (17) an einer innerhalb ihrer Länge gelegenen Stelle einen Reif (18) aufweisen und dass die Löcher (14) des Bodens (6) des Körpers (5) an der Innenseite des Bodens einen dem Reif (18) entsprechenden Durchmesser (14a) und an der Außenseite des genannten Bodens einen kleineren Durchmesser (14b) entsprechend demjenigen Ende der Pins (17) aufweisen, das zum Zusammenwirken und Verlöten mit den Leiterbahnen der gedruckten Schaltung vorgesehen ist, wobei diese zwei Durchmesser der Löcher über eine Schulter (15) verbunden sind.

3. Verbindergehäuse für elektronische Bauteile nach Anspruch 1, **dadurch gekennzeichnet, dass** die Öffnungen (35), die dazu vorgesehen sind, von den Köpfen (37) durchgriffen zu werden, an der Innenseite des Behälters die Form eines umgekehrten Kegelstumpfes (35a) und an der Außenseite des genannten Bodens die Form eines Kegelstumpfes (35) besitzen, wobei die kleinen Basen dieser Kegelstümpfe durch einen zylindrischen Zwischenteil (35b) verbunden sind.

4. Verbindergehäuse für elektronische Bauteile nach Anspruch 1, **dadurch gekennzeichnet, dass** der Körper (5) eine Reihe von Pins (17a, 17b) aufweist, die dazu vorgesehen sind, mit Stellen der gedruckten Schaltung verlötet zu sein und die Mittel zur Befestigung des genannten Körpers an der gedruckten Schaltung bilden.

5. Verbindergehäuse für elektronische Bauteile nach Anspruch 1, **dadurch gekennzeichnet, dass** die Mittel zur Verriegelung des elektronischen Bauteiles im Sitz eine Klappe (42) aufweisen, die durch eine Lamelle gebildet ist, die an einer innerhalb ihrer Länge gelegenen Stelle gewölbt und deren Konvexität dem Behälter zugewandt ist, wobei genannte Klappe (42) mit einem Ende am Körper (5) angelenkt ist, während das andere Ende mit elastischen Haken (12) in Eingriff kommt, die am Körper (5) befestigt sind.

6. Verbindergehäuse für elektronische Bauteile nach Anspruch 1, **dadurch gekennzeichnet, dass** es ein Füllstück (50) aufweist, das die Abmessungen des elektronischen Bauteiles (1) aufweist und dazu vorgesehen ist, während Lagerung, Transport und dem Anbringen des genannten Gehäuses an der gedruckten Schaltung in den Sitz eingebaut zu sein.

## Claims

1. Junction box for electronic components of the type in which one face has a series of contacts (3), said box being formed from a body (5) comprising a housing to receive the component (1), means being provided, on the one hand, to fix said body on the printed circuit (20) and, on the other hand, to ensure the electrical connection to the tracks of the printed circuit (20) and the contacts (3) of the component (1), and locking means (42) for locking the component (1) in the housing, **characterised in that** the housing consists of a receptacle (25) which is independent of said body (5) and is intended to receive the component, while said body (5) comprises a base (6) and lateral walls (7, 8), the base (6) being perforated by holes (14) intended to receive contact studs (17), intended, by a corresponding and, to cooperate and be welded on the tracks of the printed circuit, while the receptacle (25) comprises a base (26) perforated by apertures (35), in which electrical contact buttons (37) formed by an entanglement of a wire to obtain a type of elastic plug are engaged, one of the ends of the buttons (37) bearing against the corresponding end of the contact studs (17) and the other end against the contacts (3) of the electronic component (1).

2. Junction box for electronic components according to claim 1, **characterised in that** the contact studs (17) at an intermediate point of their length, comprise a hoop (18) while the holes (14) in the base (6) of the body (5), on the side of the internal face of the base, have a diameter (14a) corresponding to the hoop (18) and, on the side of the external face of said base, have a smaller diameter (14b) corresponding to the end of the studs (17) intended to cooperate and to be welded on the printed circuit tracks, these two diameters of the holes being connected by a shoulder (15).

3. Junction box for electronic components according to claim 1, **characterised in that** the apertures (35) intended to be passed through by the buttons (37) have, on the side of the internal face of the receptacle, an inverted truncated cone shape (35a) and, on the aide of the external face of said base, a truncated cone shape (35c), the small bases of these truncated cones being connected by a cylindrical intermediate part (35b).

4. Junction box for electronic components according to claim 1, **characterised in that** the body (5) comprises a series of studs (17a, 17b) intended to be welded at points of the printed circuit and constituting means for fixing said body on the printed circuit.

5. Junction box for electronic components according to claim 1, **characterised in that** the means for locking the electronic component in the housing comprise a flap (42) formed by a blade arched at an intermediate point of its length and of which the convexity is turned toward the receptacle, said flap (42) being articulated on the body (5) by one end, while the other and fits into elastic hooks (12) which are integral with the body (5).

6. Junction box for electronic components according to claim 1, **characterised in that** it comprises a wedge (50) having the dimensions of the electronic component (1) and intended to be installed in the housing during storage, transit and installation of said box on the printed circuit.
